# FASCICULE DE BREVET EUROPEEN

(11) **EP 2 510 545 B1**
(45) Date de publication et mention de la délivrance du brevet: **07.08.2013**
(21) Numéro de dépôt: 10787739.1
(22) Date de dépôt: 02.12.2010
(51) Int. Cl.: H01L 27/148

(54) **CAPTEUR D'IMAGE MULTILINEAIRE A INTEGRATION DE CHARGES**
MULTILINEARER BILDSENSOR MIT LADUNGSINTEGRATION
CHARGE-INTEGRATION MULTILINEAR IMAGE SENSOR

(30) Priorité: 09.12.2009 FR 0958796
(43) Date de publication de la demande: 17.10.2012
(73) Titulaire: E2V Semiconductors, 38120 Saint Egrève (FR)
(72) Inventeur: MAYER, Frédéric, 38500 Voiron (FR)
(74) Mandataire: Guérin, Michel
(86) Numéro de dépôt international: PCT/EP2010/068694
(87) Numéro de publication internationale: WO 2011/069880

(56) Documents cités:
- US-A- 6 046 069
- US-A1- 2006 035 401
- US-A1- 2007 064 137
- US-B1- 6 465 820

## Description

L'invention concerne les capteurs d'image linéaire à défilement et intégration de signal (ou capteurs TDI, de l'anglais : "Time Delay Integration Linear Sensors"), dans lesquels une image d'une ligne de points d'une scène observée est reconstituée par addition d'images successives prises par plusieurs lignes photosensibles observant successivement une même ligne de la scène au fur et à mesure que la scène défile devant le capteur.

Ces capteurs sont utilisés par exemple dans des scanners. Ils comprennent une barrette de plusieurs lignes parallèles de pixels photosensibles ; le séquencement des circuits de commande des différentes lignes (contrôle de temps d'exposition puis de lecture des charges photogénérées) est synchronisé par rapport au défilement relatif de la scène et du capteur, de manière que toutes les lignes du capteur voient successivement une même ligne de la scène observée. Les signaux générés par chaque ligne sont ensuite additionnés point à point pour chaque point de la ligne observée. Le document US 6,465,820 décrit un capteur d'image.

A temps d'exposition constant, la sensibilité du capteur est améliorée dans le rapport du nombre N de lignes, ou bien, à sensibilité constante, le temps d'exposition peut être divisé par N. Ce nombre N peut être par exemple de 16 ou 32 pour des applications de contrôle industriel ou des applications d'observation terrestre à partir de l'espace, ou même de 60 à 100 lignes pour des applications médicales (dentaire, mamographie, ...).

Le rapport signal/bruit est amélioré dans le rapport de la racine carrée du nombre N de lignes du capteur.

De plus, les non-uniformités de sensibilité des pixels d'une même barrette, et les non-uniformités de courant d'obscurité des pixels, sont diminuées par suite du moyennage qui résulte de l'addition des signaux des différentes lignes.

Dans les capteurs d'image à transfert de charges (capteurs CCD), l'addition des signaux point à point se fait simplement en vidant dans une ligne de pixels les charges générées et accumulées dans la ligne de pixels précédente, en synchronisme avec le déplacement relatif de la scène et du capteur. La dernière ligne de pixels, ayant accumulé N fois les charges engendrées par la ligne d'image observée, peut être lue.

La technologie habituelle des capteurs d'image CCD est relativement chère, elle utilise des tensions d'alimentation élevées et consomme une énergie importante ; cette technologie est basée sur l'utilisation de grilles de silicium polycristallin adjacentes et en recouvrement mutuel.

La technologie des capteurs d'image a ensuite évolué vers des capteurs à pixels actifs à transistors, qu'on appellera ci-après capteurs CMOS pour simplifier car ils sont en général réalisés en technologie CMOS (complementary-metal-oxyde-semiconducteur) ; dans ces capteurs CMOS il n'y a plus de transfert de charges de ligne en ligne vers un circuit de lecture ou un registre mais il y a des pixels actifs à transistors qui recueillent des charges électriques photogénérées et les convertissent directement en une tension ou un courant. Les différentes lignes du capteur fournissent donc successivement des tensions ou courants représentant l'éclairement reçu par la ligne. Ces structures ne permettent pas de réaliser des sommations sans bruit de ces courants ou tensions ; il est donc difficile de réaliser un capteur à défilement et à intégration de charges. La technologie de fabrication est cependant simple, elle consomme peu, et elle fonctionne sous basse tension.

Des tentatives ont cependant été faites pour réaliser des capteurs CMOS à défilement et intégration de charges.

On a essayé en particulier d'utiliser des capacités commutées dans lesquelles on intègre des courants successifs reçus, accumulant ainsi sur une même capacité des charges reçues de plusieurs pixels en colonne (US6906749, WO0126382).

On a également proposé de convertir en valeurs numériques les signaux issus d'une ligne de pixels, de sommer la valeur numérique correspondant au pixel de rang j de la ligne dans un registre accumulateur de rang j qui accumule les valeurs numériques correspondant aux pixels de même rang j de N lignes successives (brevet FR2906080).

Dans le brevet FR2906081, on a proposé d'appliquer à la photodiode d'un pixel d'une ligne la tension de sortie d'un pixel d'une ligne précédente, pour y recopier les charges du pixel précédent, avant d'isoler la photodiode et d'intégrer de nouvelles charges dues à la lumière, de sorte qu'à la fin d'un temps d'intégration la photodiode comprend la somme des charges correspondant à la ligne précédente et les nouvelles charges intégrées. Ce fonctionnement induit cependant un bruit de transfert qui détériore le rapport signal/bruit.

Enfin, des solutions utilisant une accumulation de charges à l'intérieur du pixel ont été proposées, par exemple dans la publication de brevet US2008/0217661. Elles utilisent une technologie plus complexe que celle qui est strictement nécessaire pour réaliser des capteurs d'image en technologie CMOS, ou bien elles présentes des pertes lors des transferts de charges.

Les tentatives pour réaliser un capteur linéaire à défilement et intégration de charges utilisant une technologie plus simple que la technologie CCD habituelle n'ont donc pas donné satisfaction.

L'invention a pour but de proposer une solution plus avantageuse pour réaliser des capteurs fonctionnant selon le principe des structures à transfert de charges mais utilisant une technologie compatible avec des circuits de technologie CMOS, et notamment une technologie n'utilisant qu'un seul niveau de grille en silicium polycristallin et non un double niveau de grilles en recouvrement mutuel comme c'est le cas dans les technologies CCD classiques.

Selon l'invention, on propose un capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image dans les pixels de même rang des différentes lignes, les pixels adjacents de même rang comprenant chacun une alternance d'au moins une photodiode et une grille de transfert adjacente à la photodiode, les photodiodes comprenant une région de référence commune d'un premier type de conductivité (en pratique un type p), dans laquelle est formée une région individuelle de type opposé (n) elle-même recouverte par une région superficielle individuelle du premier type (p), caractérisé en ce que les régions superficielles de deux photodiodes situées de part et d'autre d'une grille de transfert sont électriquement isolées l'une de l'autre et électriquement isolées de la région de référence commune, et en ce que le capteur comporte des moyens pour porter ces régions à des potentiels différents l'un de l'autre et variables cycliquement.

L'isolation à laquelle il est fait référence ici n'est pas une isolation absolue par une résistance infinie : elle peut être faite par une zone suffisamment résistive pour permettre de porter les régions superficielles de photodiodes adjacentes à des potentiels différents qui servent à exécuter les transferts de charge, sans que la région de référence commune impose son niveau général de potentiel à ces régions superficielles.

En pratique, cette isolation électrique résulte principalement de ce que :
- isolation dans le sens des colonnes : les régions semiconductrices peu dopées situées sous les grilles et adjacentes aux régions superficielles du premier type sont déplétées de leurs porteurs en raison des potentiels appliqués aux grilles ; ces régions sont donc fortement résistives et isolent électriquement (même s'il y a de petits courants de fuite) les régions superficielles des parties non déplétées de la région de référence commune (qui sont à un potentiel général commun) ; de ce fait elles isolent également les unes des autres les régions superficielles de photodiodes adjacentes ;
- isolation entre colonnes : s'il y a des régions fortement dopées du premier type (de type p+ ou p++) entre les colonnes, on prévoit que des régions du second type (n) sont interposées entre ces régions fortement dopées et la couche de référence commune (type p), de manière à ne pas relier les régions superficielles des photodiodes à cette couche de référence par l'intermédiaire de ces régions fortement dopées.

Dans l'art antérieur, les régions superficielles des photodiodes sont reliées électriquement, par des zones fortement dopées (p+) à la région de référence commune (p) et leur potentiel ne peut pas être différent de celui de la région de référence ; il n'est donc pas possible de porter les régions superficielles à des potentiels différents les uns des autres.

En agissant sur le niveau des barrières de potentiel créées sous les grilles de transfert séparant les différentes photodiodes, et en agissant en même temps sur les niveaux de potentiel des régions superficielles des photodiodes, on peut cycliquement, au moyen d'un circuit de séquencement,
- créer un puits de potentiel sous une première photodiode pour y accumuler des charges ;
- en même temps monter le fond du puits de potentiel d'une deuxième photodiode adjacente à la première pour que les charges générées par la deuxième photodiode se déversent dans la première ;
- ensuite vider l'ensemble des charges de la première photodiode vers la deuxième ;
- puis recommencer un cycle dans lequel la deuxième photodiode, ayant déjà reçu des charges, joue le rôle d'une première photodiode vis-à-vis d'une autre photodiode appartenant à une autre ligne de pixels.

L'organisation des lignes de pixels est de préférence la suivante, dans laquelle toutes les lignes de pixels sont commandées par des signaux identiques : un pixel d'une ligne de rang intermédiaire entre la première ligne et la dernière ligne comporte une succession, dans le sens perpendiculaire à la direction des lignes de pixels, d'une première grille de transfert, permettant l'établissement d'une barrière de potentiel de hauteur variable, une première photodiode adjacente à la première grille, une deuxième grille de transfert adjacente à la première photodiode et permettant l'établissement d'une barrière de potentiel de hauteur variable, et une deuxième photodiode adjacente à la deuxième grille et adjacente à la première grille d'un pixel d'une ligne suivante ; des moyens de séquencement sont prévus pour appliquer aux régions superficielles des premières et deuxièmes photodiodes des potentiels différents et variables au cours d'un cycle d'intégration et de transfert de charges, et pour appliquer aux grilles de transfert des potentiels différents et variables au cours du cycle.

De préférence, les moyens de séquencement sont agencés pour appliquer aux photodiodes et aux grilles de toutes les lignes des potentiels qui varient périodiquement selon quatre phases successives :
- une première phase d'intégration dans laquelle les charges générées par la lumière dans la première photodiode d'un pixel sont accumulées par la première photodiode tandis que les charges générées par la lumière dans la deuxième photodiode se déversent de la deuxième photodiode vers la première en passant sous la deuxième grille et en s'accumulant dans la première photodiode,
- une première phase de transfert dans laquelle les charges accumulées dans la première photodiode sont transférées dans la deuxième photodiode,
- une deuxième phase d'intégration dans laquelle les charges générées par la lumière dans la deuxième photodiode sont accumulées par la deuxième photodiode tandis que les charges générées par la lumière dans la première photodiode du pixel de la ligne suivante se déversent vers la deuxième photodiode en passant sous la première grille de transfert du pixel de la ligne suivante et en s'accumulant dans la deuxième photodiode.
- et une deuxième phase de transfert dans laquelle les charges accumulées dans la deuxième photodiode sont transférées dans la première photodiode du pixel de la ligne suivante en passant sous la première grille de transfert du pixel de la ligne suivante.

Dans une réalisation particulière, les potentiels appliqués à la région superficielle de la deuxième photodiode respectivement pendant la première phase de transfert et pendant la deuxième phase d'intégration sont choisis de manière à créer un puits de potentiel sous la deuxième photodiode plus profond pendant la première phase de transfert que pendant la deuxième phase d'intégration. Et on fait de même pour la première photodiode respectivement pendant la deuxième phase de transfert et la première phase d'intégration. Dans ce cas, on choisit de préférence d'abaisser la barrière de potentiel sous la deuxième grille de transfert pendant la première phase de transfert plus que pendant la première phase d'intégration, et de même on choisit d'abaisser la barrière de potentiel sous la première grille de transfert plus pendant la deuxième phase de transfert que pendant la deuxième phase d'intégration.

Les différents pixels d'une même ligne sont séparés par des zones d'isolation qui sont de préférence constituées par la superposition
- d'une région d'isolation du premier type de conductivité, adjacente aux régions superficielles dopées du premier type appartenant aux photodiodes mais plus dopées que ces régions superficielles
- et d'une région d'isolation du deuxième type de conductivité qui isole entièrement la région d'isolation du premier type de la région de référence commune du premier type.

Les régions d'isolation du premier type de conductivité touchent les régions superficielles des photodiodes et elles peuvent servir à y amener les potentiels de commande désirés.

D'autres caractéristiques et avantages de l'invention apparaîtront à la lecture de la description détaillée qui suit et qui est faite en référence aux dessins annexés dans lesquels :
- la figure 1 représente une vue en coupe, perpendiculairement au sens des lignes, de la structure d'un capteur photosensible multilinéaire selon l'invention ;
- la figure 2 représente le profil de potentiel à l'intérieur du semiconducteur dans une superposition de conductivités p+/n/p/p++ ;
- la figure 3 représente le diagramme des potentiels créés dans le semiconducteur avec les puits de potentiel et les barrières de potentiel dans les différentes phases d'intégration et de transfert ;
- la figure 4 représente un chronogramme des signaux de commande du capteur ;
- la figure 5 représente une coupe du capteur parallèlement aux lignes de pixels et les potentiels internes correspondants ;
- la figure 6 représente les potentiels internes dans des structures p+/n/p/p++ ayant des structures de dopages différentes ;
- la figure 7 représente une vue de dessus montrant la séparation latérale entre pixels d'une même ligne ;
- la figure 8 représente une autre vue de dessus dans laquelle la forme biseautée des photodiodes facilite le déversement des charges électriques vers les photodiodes adjacentes ;
- la figure 9 représente une vue d'une structure d'anti-éblouissement pouvant être associée aux régions d'isolation entre pixels d'une même ligne ;
- la figure 10 représente un circuit de lecture après la N^{ième} ligne de pixels.

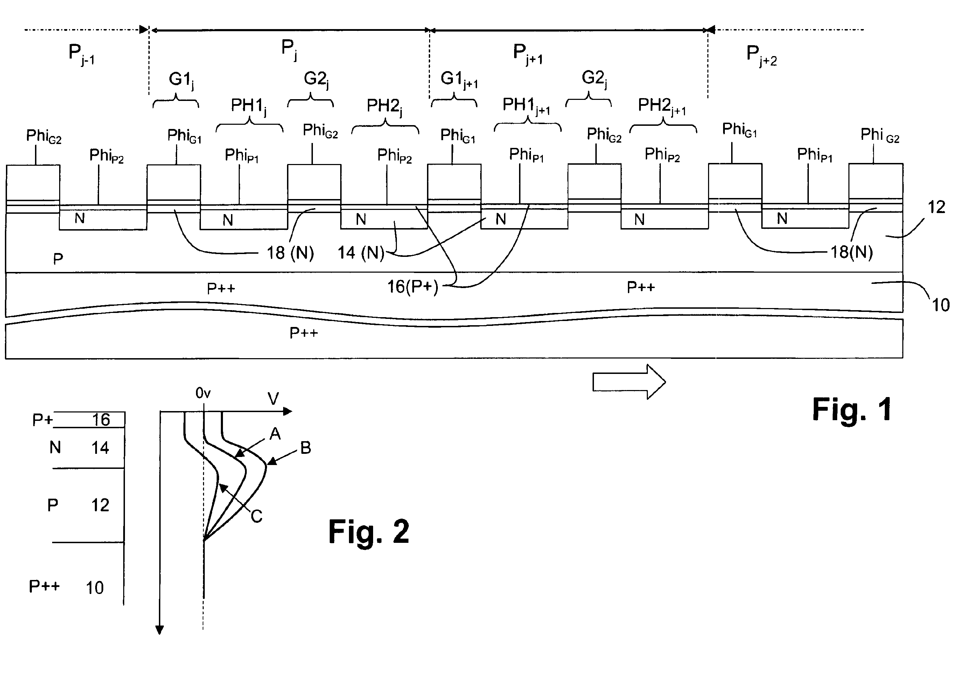

La vue en coupe de la figure 1 représente plusieurs pixels successifs d'une même colonne dans une barrette de capteur d'image comportant N lignes adjacentes de P pixels chacune, la barrette étant destinée à fonctionner en mode TDI ; chaque ligne de rang j (j=1 à N) lit successivement une même ligne d'image au cours d'un défilement synchronisé de l'image par rapport à la barrette dans le sens perpendiculaire au sens des lignes ; les charges des pixels de même rang i (i=1 à P) dans les différentes lignes correspondent à l'observation d'un même point d'image et sont accumulées pour obtenir un signal plus important (pour un temps d'exposition donné de chaque ligne de pixel) que si une seule ligne voyait l'image, avec une amélioration du rapport signal sur bruit.

On a représenté essentiellement les pixels Pⱼ et Pⱼ₊₁ de rang j et j+1 respectivement d'une colonne.

Les pixels sont formés dans un substrat semiconducteur 10 dont la partie supérieure est une couche semiconductrice épitaxiale peu dopée 12. Dans cet exemple, le substrat est de type p++ fortement dopé, et la couche épitaxiale est de type p. Si la couche épitaxiale était de type n, il faudrait inverser tous les types de conductivité qui vont maintenant être définis, ainsi que les signes des potentiels appliqués aux photodiodes et aux grilles. Le substrat est en principe de même type de conductivité que la couche épitaxiale, mais il pourrait également être de type opposé.

Les colonnes comportent une alternance de photodiodes et de grilles de transfert de charges. On peut considérer qu'un groupe d'une photodiode et une grille adjacente constitue soit un demi-pixel, les pixels étant commandés tous en phase, soit un pixel entier, les pixels adjacents étant alors commandés en opposition de phase. Dans ce qui suit on considérera qu'une photodiode et une grille adjacente constituent un demi-pixel, tous les pixels du capteur recevant les mêmes signaux de commande.

Chaque pixel comporte donc deux photodiodes PH1, PH2 et deux grilles de commande de transfert de charges G1, G2 adjacentes aux photodiodes. Les photodiodes et grilles sont affectées des indices j et j+1 sur la figure 1 pour les pixels Pⱼ et Pⱼ₊₁ respectivement. Les grilles sont des grilles de silicium polycristallin, isolées de la couche épitaxiale 12 par une fine couche isolante (oxyde ou nitrure de silicium). Les photodiodes sont réalisées par un empilement comprenant : la couche épitaxiale 12 de type p (couche de référence commune pour toutes les photodiodes de tous les pixels), une région individuelle 14 de type n diffusée dans la couche épitaxiale entre deux grilles de transfert, et une région superficielle individuelle 16 de type p+, plus dopée que la couche épitaxiale, recouvrant la région individuelle 14. Les électrons générés par l'éclairement pourront s'accumuler dans des puits de potentiel formés à la jonction NP entre la région n et la couche épitaxiale p.

Plus précisément, le pixel de rang j comporte, juxtaposés dans le sens de la colonne, de gauche à droite sur la figure 1 :
- une première grille de transfert G1ⱼ
- une première photodiode PH₁ⱼ,
- une deuxième grille de transfert G2ⱼ,
- une deuxième photodiode PH2ⱼ,
et la deuxième photodiode du pixel Pⱼ est immédiatement suivie de la première grille de transfert du pixel suivant Pⱼ₊₁, de même que la première grille de transfert du pixel Pⱼ est immédiatement précédée de la deuxième photodiode du pixel précédent Pⱼ₋₁.

Les signaux de commande de toutes les premières et deuxièmes grilles de transfert G1 et G2 sont des signaux à potentiel variable Phi_{G1} et PhiG2 appliqués à ces grilles. Les signaux de commande des photodiodes PH1 et PH2 sont des signaux à potentiel variable Phi_{P1} et Phi_{P2} appliqués à la région superficielle 16 de type p+ de la photodiode correspondante. Ces signaux sont produits par un circuit de séquencement non représenté. On verra plus loin comment on peut amener ces signaux aux photodiodes.

Dans le fonctionnement en mode TDI, le sens de transfert des charges dépend des potentiels appliqués. On considérera ici que le transfert se fait de la gauche vers la droite, mais la structure du capteur selon l'invention permet de choisir le sens à volonté, ce qui est avantageux. Le déplacement de l'image par rapport aux lignes de la barrette doit être synchronisé et doit correspondre au sens de transfert.choisi.

L'application d'un potentiel variable sur une région superficielle p+ d'une photodiode crée un puits de potentiel de profondeur variable à peu près à la jonction entre la région n de cette photodiode et la couche épitaxiale. La figure 2 explique ce phénomène : sur cette figure, on a représenté le profil de potentiel interne dans la structure semiconductrice p+/n/p/p++ qui forme la photodiode (en l'absence de charges photogénérées). Le potentiel de référence considéré comme égal à zéro est celui du substrat p++. L'axe des abscisses, dirigé vers le bas sur la figure 2, représente la profondeur croissante à partir de la région superficielle p+ en descendant vers le substrat p++ ; l'axe des ordonnées représente le potentiel maximum V à la profondeur considéré. Trois courbes A, B, C sont représentées. La courbe A représente le profil de potentiel quand on porte à 0 volt la région superficielle ; le profil présente un pic de potentiel positif (puits de potentiel pour les électrons) autour de la jonction entre la région n et la couche épitaxiale p. Lorsqu'on applique un potentiel plus positif à la région superficielle p+ (courbe B), le puits de potentiel se creuse d'autant plus que le potentiel appliqué est plus haut. Lorsqu'on applique un potentiel plus négatif à la région superficielle (courbe C), la profondeur du puits de potentiel se réduit d'autant plus que le potentiel appliqué est plus bas.

Par ailleurs, au-dessous d'une grille de transfert se crée une barrière de potentiel d'autant plus élevée que le potentiel appliqué à la grille est bas. Les potentiels appliqués aux grilles sont choisis en fonction du niveau des puits de potentiel créés dans les photodiodes, selon qu'on veut accumuler des charges dans une photodiode ou les déverser d'un côté ou de l'autre de la photodiode.

Enfin, on isole électriquement les unes des autres les régions superficielles 16 des différentes photodiodes d'une même colonne afin de pouvoir les porter à des potentiels différents et ainsi effectuer des transferts de charge. Il ne s'agit pas d'une isolation parfaite en ce sens que des courants de fuite peuvent exister. L'isolation consiste notamment à séparer électriquement les régions superficielles 16 de la couche commune de référence de type p afin que cette couche ne serve pas à uniformiser le potentiel des régions superficielles p+ comme c'est le cas dans l'art antérieur. Cette isolation ou séparation électrique résulte de :
- entre deux photodiodes d'une même colonne l'isolation résulte d'une déplétion des zones semiconductrices située sous les grilles ; ces zones semiconductrices sont peu dopées et sont fortement résistives si elles sont déplétées de porteurs ; elles empêchent les régions superficielles 16 d'être en contact direct avec la couche épitaxiale 12 ;
- sous une photodiode, l'isolation de la région 16 est faite par la région 14 de type n.
- enfin, entre photodiodes d'une même ligne on verra qu'il n'y a pas besoin d'une isolation car toutes les régions superficielles d'une même ligne peuvent être portées au même potentiel, mais il faut faire attention à ne pas relier directement ces régions à la couche épitaxiale par des diffusions fortement dopées qui seraient placées entre les colonnes ; on reviendra ultérieurement sur ce point.

Les zones semiconductrices situées sous les grilles G1 et G2 font partie de la couche épitaxiale et sont soit dopées comme elle, soit dopées un peu plus si on veut ajuster la tension de seuil de conduction sous les grilles, mais dans tous les cas, le dopage est suffisamment faible pour que la résistivité de ces zones soit très élevée lorsqu'elles sont déplétées. La valeur du dopage maximal admissible dépend des courants de fuite qu'on accepte. Le potentiel appliqué aux grilles est suffisamment faible pour que la déplétion se produise sur une profondeur au moins égale à la profondeur des régions 16.

L'invention utilise ces remarques pour commander l'accumulation de charges dans les photodiodes et le transfert ultérieur de ces charges avec sommation des charges des différentes photodiodes d'une même colonne.

Le fonctionnement est globalement le suivant pour un cycle complet de transfert d'un pixel d'une ligne vers le pixel de même rang de la ligne suivante :
- pendant un premier temps d'intégration le potentiel appliqué à la région p+ des premières photodiodes PH1 est un potentiel suffisamment haut pour créer un puits de potentiel dans lequel s'accumulent les charges générées dans ces photodiodes par la lumière ; ce potentiel haut peut être égal à zéro (cf courbe A de la figure 2) ; ces charges s'additionnent aux charges déjà présentes dans cette photodiode et qui résultent d'un cycle de transfert de charge précédent ; au même moment le potentiel appliqué aux deuxièmes photodiodes PH2 est un potentiel bas empêchant l'accumulation de charges dans les deuxièmes photodiodes ; de plus le potentiel de la grille G2ⱼ qui sépare la photodiode PH2ⱼ de la première photodiode PH1ⱼ du même pixel est suffisamment haut pour autoriser un écoulement de charges issues de cette deuxième photodiode vers la première photodiode ; le potentiel de la grille G1ⱼ₊₁ du pixel suivant est au contraire suffisamment bas pour créer une barrière de potentiel empêchant le passage de charges de la deuxième photodiode PH2ⱼ vers le pixel suivant Pⱼ₊₁ ; il en résulte que la première photodiode accumule toutes les charges générées par la lumière dans les deux photodiodes du pixel, en plus des charges déjà présentes en début de cycle ;
- à la fin du premier temps d'intégration les potentiels des grilles et des photodiodes sont modifiés de manière à assurer un transfert de toutes les charges de la première photodiode du pixel vers la deuxième photodiode du pixel ;
- pendant un deuxième temps d'intégration, les rôles des premières et deuxièmes photodiodes sont inversés ; le potentiel des deuxièmes photodiodes PH2 est un potentiel suffisamment haut (0 volt peut suffire là encore) pour créer un puits de potentiel dans lequel s'accumulent les charges générées dans ces photodiodes par la lumière ; au même moment le potentiel appliqué aux premières photodiodes PH1 est un potentiel bas empêchant le creusement d'un puits de potentiel ; de plus le potentiel de la grille G1ⱼ₊₁ qui sépare la photodiode PH2ⱼ de la première photodiode PH1ⱼ₊₁ du pixel suivant est suffisamment haut pour autoriser un écoulement de charges issues de cette première photodiode suivante vers la deuxième photodiode PH2ⱼ ; le potentiel de la grille G2ⱼ du pixel est suffisamment bas pour créer une barrière de potentiel empêchant le passage de charges de la deuxième photodiode PH2ⱼ vers la première PH1ⱼ ainsi que le passage de charges de la première photodiode PH1ⱼ vers la deuxième ; il en résulte que la deuxième photodiode du pixel Pⱼ accumule ses charges propres et celles de la première photodiode du pixel suivant Pⱼ₊₁ ;
- à la fin du deuxième temps d'intégration, les potentiels des grilles et des photodiodes sont modifiés de manière à assurer un transfert de toutes les charges de la deuxième photodiode PH2ⱼ vers la première photodiode PH1ⱼ₊₁ du pixel suivant ; cette photodiode PH1ⱼ₊₁, reçoit donc à ce moment des charges qui sont l'addition de trois composantes : les charges précédemment accumulées par la photodiode PH1ⱼ avant le premier temps d'intégration, les charges accumulées par les diodes PH1ⱼ et PH2ⱼ pendant le premier temps d'intégration, et les charges accumulées par les photodiodes PH2ⱼ et PH1ⱼ₊₁, pendant le deuxième temps d'intégration.

Un nouveau cycle de deux intégrations et deux transferts de charge peut alors recommencer. Les cycles se terminent après l'intégration dans un dernier pixel de rang N lorsqu'une ligne d'image cesse d'être observée par la barrette. Les charges accumulées dans chaque colonne par N lectures d'une même ligne d'image sont disponibles dans la deuxième photodiode à la fin du deuxième temps d'intégration du N^{ième} cycle et elles peuvent être lues.

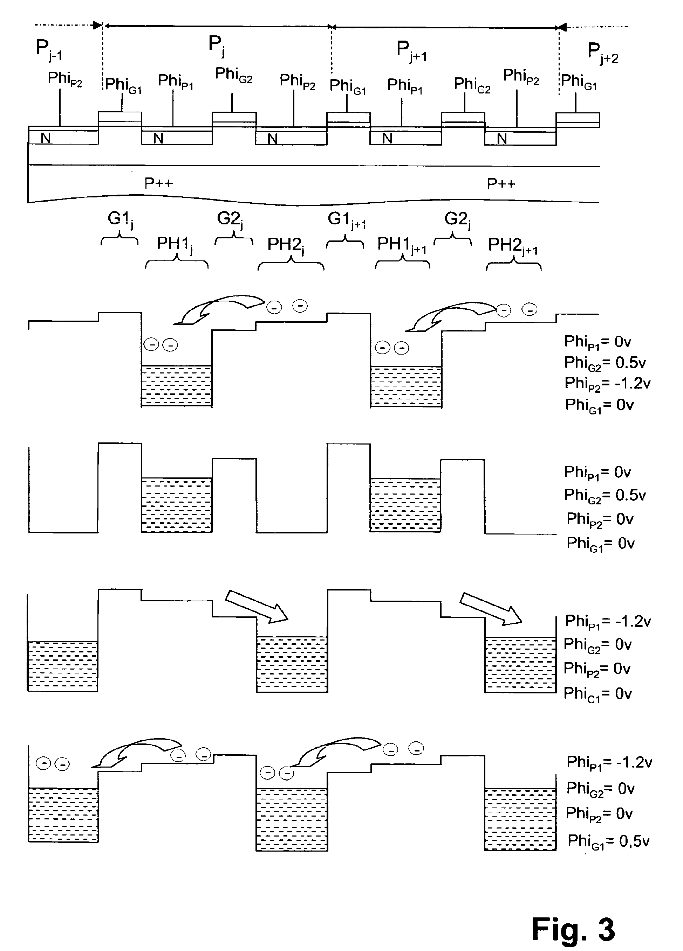

La figure 3 représente schématiquement, au-dessous de la structure de pixels selon l'invention, le diagramme des potentiels dans la couche épitaxiale 12, en fonction des potentiels appliqués aux grilles et aux régions superficielles des diodes. Les potentiels les plus négatifs sont vers le haut, les potentiels plus positifs vers le bas, de manière à faire apparaître les puits de potentiel et les barrières qui les encadrent.

Pendant la première phase d'intégration (diagramme du haut), le potentiel Phi_{P1} appliqué aux premières photodiodes est un potentiel nul créant un puits de potentiel profond ; le potentiel Phi_{P2} appliqué aux deuxièmes photodiodes est un potentiel négatif (ici : -1,2 volts) créant dans le semiconducteur un potentiel nettement moins élevé que le fond du puits de potentiel présent sous les premières photodiodes ; les deux grilles de transfert G1ⱼ et G2ⱼ sont portées à des potentiels bas Phi_{G1} et Phi_{G2} qui créent des barrières de potentiel fermant les puits de potentiel présents sous les premières photodiodes ; les hauteurs de ces barrières sont différentes ; sous la grille G1ⱼ, la barrière est légèrement plus haute que le potentiel créé par Phip₂ sous les deuxièmes photodiodes (retenant les charges créées sous ces dernières) ; sous la grille G2ⱼ, la barrière est au contraire plus basse que ce potentiel, de sorte que les électrons engendrés par la lumière dans les deuxièmes photodiodes ne peuvent pas s'accumuler, ne peuvent pas se déverser vers le pixel suivant, et ne peuvent donc que se déverser dans les premières photodiodes. Dans cet exemple, pour obtenir ce résultat on applique un potentiel de 0 volt aux premières grilles de transfert G1 et un potentiel positif de 0,5 volts aux deuxièmes grilles G2, mais on comprendra que les valeurs de potentiel appliqués dépendent des profondeurs et niveaux de dopage des diverses couches semiconductrices ou isolantes.

A la fin de ce premier temps d'intégration, on modifie les potentiels de la manière suivante pour exécuter un transfert de charges en deux étapes. Dans une première étape de transfert, on porte la région superficielle p+ des deuxièmes photodiodes à un potentiel nul (Phi_{P2} = 0), abaissant le potentiel dans le semiconducteur (deuxième diagramme de la figure 3 en partant du haut) et créant un fond de puits de potentiel (vide) à cet endroit. Dans une deuxième étape (troisième diagramme de la figure 3), on relève le niveau du fond de puits de potentiel encore présent sous les premières photodiodes jusqu'à une valeur intermédiaire entre le potentiel sous les premières grilles G1 et les deuxièmes grilles G2. Dans cet exemple, on porte d'abord à 0 volts le potentiel Phi_{P2} appliqué aux deuxièmes photodiodes (première étape), puis on porte à -1,2 volts le potentiel Phi_{P1} appliqué aux premières photodiodes (deuxième étape). Les charges précédemment stockées dans les puits sous les premières photodiodes ne peuvent que se déverser dans les puits de potentiel sous les deuxièmes photodiodes. Il y a un transfert total vers la deuxième photodiode des charges accumulées dans la première photodiode.

Ce premier temps d'intégration et le premier transfert de charges forment la moitié du cycle de transfert d'une ligne vers la suivante. La deuxième moitié du cycle est identique à la première moitié, mais en inversant les rôles des premières et deuxièmes photodiodes et en inversant les rôles des premières et deuxièmes grilles. Il y a d'abord un deuxième temps d'intégration (quatrième diagramme de la figure 3) et un deuxième transfert de charges. Dans le deuxième temps d'intégration, les charges générées par la lumière dans la deuxième photodiode du pixel PH2ⱼ s'accumulent dans cette photodiode, alors que les charges générées par la lumière dans la première photodiode PH1ⱼ₊₁ du pixel suivant Pⱼ₊₁ se déversent dans la deuxième photodiode PH2ⱼ du pixel Pⱼ.

A la fin du deuxième temps d'intégration on effectue un deuxième transfert de charges (non représenté), identique au premier mais en inversant les rôles des deux photodiodes et les rôles des deux grilles de transfert. Le deuxième transfert de charges transfère vers la première photodiode du pixel suivant Pⱼ₊₁ toutes les charges qui étaient stockées dans la deuxième photodiode du pixel courant Pⱼ.

Ce deuxième transfert marque la fin d'un cycle : la première photodiode du pixel Pⱼ₊₁ contient maintenant la somme des charges accumulées lors de la lecture d'un point d'image par tous les pixels P₁ à Pⱼ ; les charges résultant de la lecture du même point d'image par le pixel Pⱼ₊₁ seront ajoutées au cycle suivant.

On notera que le sens des potentiels appliqués permet de faire un transfert de charges progressif de la gauche vers la droite, mais on pourrait aussi prévoir un transfert de la droite vers la gauche en inversant systématiquement les potentiels appliqués aux grilles G1 et G2 aussi bien pendant les phases d'intégration que pendant les phases de transfert.

Dans l'exemple de choix de niveaux de puits et de barrières de potentiels représenté à la figure 3, on a considéré que le niveau de potentiel engendré sous la deuxième photodiode au moment du premier transfert de charges, entre les deux intégrations, est identique au niveau du fond de puits de potentiel pendant les intégrations. Toutefois, en variante, on peut creuser un peu plus le puits de potentiel pendant les transferts (pour accélérer ce transfert) en appliquant un potentiel positif au lieu d'un potentiel nul sur la région superficielle de la photodiode qui va recevoir les charges transférées.

De plus, dans ce cas, on peut aussi prévoir d'abaisser temporairement la barrière de potentiel sous la grille qui autorise ce transfert, pendant la deuxième étape du transfert de charges (alors que dans le cas de la figure 3 le potentiel appliqué à la grille G2 reste fixe jusqu'au début de la deuxième intégration).

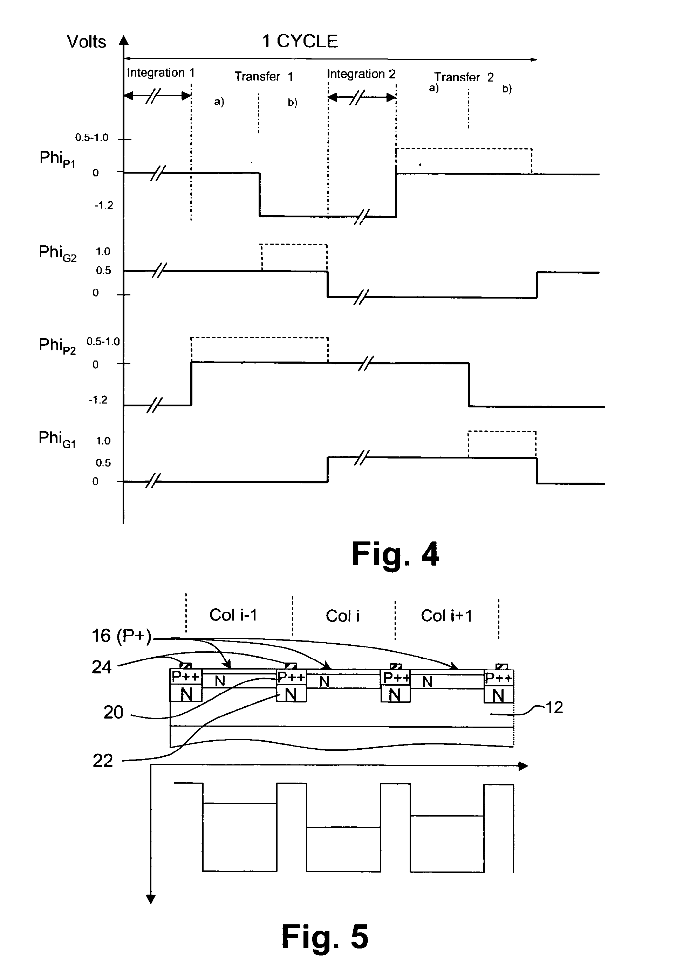

La figure 4 représente un chronogramme possible pour les potentiels de commande appliqués aux photodiodes pendant un cycle de deux temps d'intégration et de deux transferts. On y voit le premier temps d'intégration (Phi_{P1} = 0, Phi_{P2} négatif, Phi_{G1}= 0, Phi_{G2} positif) ; puis la première étape du premier transfert (Phi_{P2} passe à zéro, ou même à une valeur positive) ; la deuxième étape du premier transfert (Phi_{P1} devient négatif, et Phi_{G2} peut rester constant, ou augmenter mais de préférence seulement si Phi_{P2} est devenu positif) ; puis le deuxième temps d'intégration (valeurs de Phi_{P1} et Phi_{P2} permutées par rapport au premier temps d'intégration, valeurs de Phi_{G1} et Phi_{G2} également permutées) ; puis les deux étapes du deuxième temps de transfert (valeurs de Phi_{P1} et Phi_{P2} permutées par rapport au premier temps de transfert, valeurs de Phi_{G1} et Phi_{G2} également permutées).

La figure 5 représente une coupe de la structure dans un sens parallèle aux lignes de la barrette ; on y voit trois colonnes juxtaposées, de rang i-1, i et i+1. Les photodiodes d'une même ligne sont séparées par des structures d'isolation qui comprennent des diffusions 20 de type p++ recouvrant chacune une région n 22 qui peut être plus profonde que les régions n des photodiodes mais qui reste adjacente aux régions n des photodiodes. Par le symbole p++ affecté aux régions 20, on entend que ces régions 20 sont plus dopées que les régions superficielles 16 de type p+.

Ces structures d'isolation jouent deux rôles :
- d'une part elles séparent les uns des autres les puits de potentiel des photodiodes adjacentes de colonnes différentes, en constituant des barrières de potentiel empêchant le mélange des charges d'un pixel d'une colonne et d'un pixel adjacent d'une autre colonne ;
- d'autre part elles sont en contact avec les régions superficielles p+ des photodiodes et elles permettent d'appliquer un potentiel désiré à ces régions superficielles.

Les régions 20 sont entièrement isolées de la couche épitaxiale par les régions 22. En effet, si elles étaient en contact avec la couche épitaxiale de type p on ne pourrait pas appliquer des potentiels différents aux régions superficielles p+ des différentes photodiodes sans créer des courants de fuite rédhibitoires.

Par conséquent, les régions 20 sont directement adjacentes aux régions superficielles p+ des photodiodes, mais elles sont par ailleurs entièrement entourées latéralement par les régions n des photodiodes, et elles sont enfermées vers le bas par les régions 22 de type n ; elles ne sont pas adjacentes aux parties non déplétées de la couche épitaxiale 12 de type p (elles sont en effet adjacentes à la couche épitaxiale 12 sous les grilles mais là où cette couche est déplétée et donc fortement résistive).

On notera qu'on n'a pas besoin de d'isoler électriquement les régions superficielles 16 de photodiodes adjacentes dans le sens des lignes car un potentiel commun Phi_{P1} (pour les premières photodiodes PH1) ou Phi_{P2} (pour les deuxièmes photodiodes) est appliqué à toutes les photodiodes adjacentes d'une même ligne.

Un contact électrique 24 est formé sur les régions p++ 20 (pas forcément sur toutes, sachant que les régions p++ d'une même ligne sont électriquement en contact par l'intermédiaire des régions p+ 16 de cette ligne). Les contacts 24 ne sont pas forcément dans le plan de coupe de la figure 5, mais ils ont été représentés par commodité sur cette figure.

Par les contacts 24, on applique les potentiels Phi_{P1} et Phi_{P2}, de sorte qu'il n'est pas nécessaire de prévoir des contacts spécifiques sur les régions superficielles p+ 16 elles-mêmes qui sont en principe moins profondes et donc peu adaptées à recevoir un contact métallique.

Bien que les régions superficielles p+ des photodiodes et les régions d'isolation 20 p++ soient portées au même potentiel, on fait en sorte que le profil de potentiel à l'intérieur du semiconducteur ne soit pas le même dans les photodiodes et dans les structures d'isolation entre photodiodes d'une même ligne. Il faut en effet créer une barrière de potentiel qui empêche le passage de charges stockées entre les photodiodes de colonnes voisines. Pour cela, il faut créer des profils de dopage dans le semiconducteur différents dans les structures d'isolation 20, 22 et dans les photodiodes. Si on augmente fortement le rapport des concentrations en impuretés entre la concentration dans la région 20 et la région 22 (en comparaison du rapport entre les concentrations dans les régions 16 et 14 des photodiodes), on atténue considérablement la profondeur du puits de potentiel créé autour de la jonction entre la région 22 et la couche épitaxiale. Le puits de potentiel relativement profond créé sous la photodiode jouxte alors un puits de potentiel très peu profond créé sous les régions d'isolation. Cela revient à dire qu'une barrière de potentiel, telle que représentée dans la partie basse de la figure 5, sépare les puits de potentiel créés sous deux photodiodes adjacentes alors que le potentiel appliqué aux régions 20 et 16 est le même puisque c'est par la région 20 qu'on applique un potentiel à la région 16. En pratique, le dopage dans la région 22 est le même que dans les régions 14, mais le dopage dans la région 20 est plus élevé que dans la région 16 (et de préférence la profondeur de la région 20 est supérieure à la profondeur de la région 16).

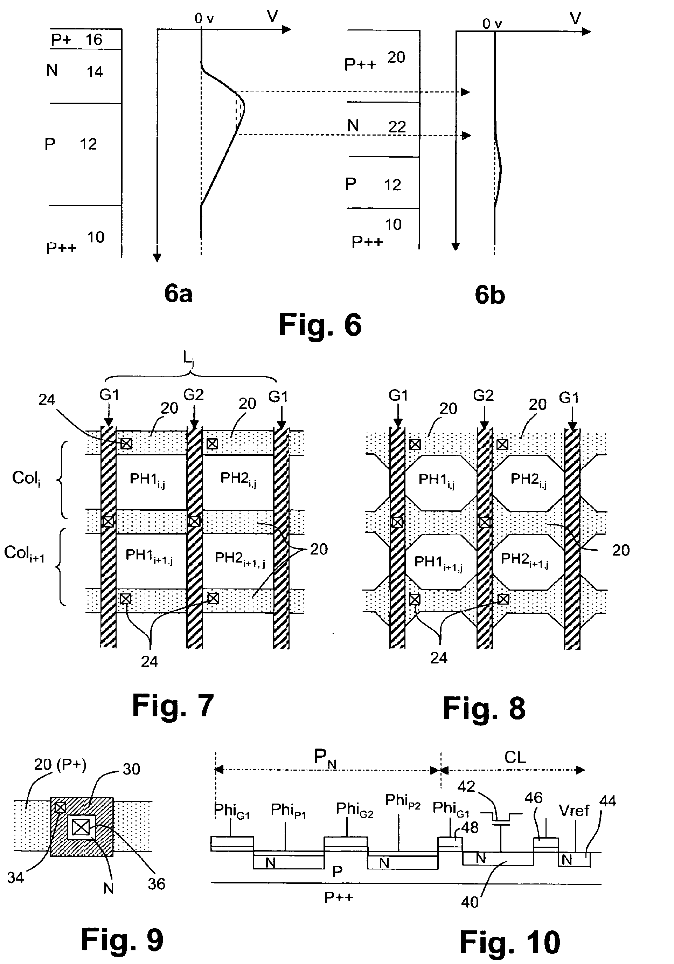

La figure 6 explique plus en détail la raison de l'existence de cette barrière de potentiel obtenue par des profils de dopage différents.

La figure 6, dessinée comme la figure 2, montre le profil des potentiels à l'intérieur du semiconducteur en l'absence de charges photogénérées, pour deux profils de dopage différents, à savoir le profil sous la photodiode (figure 6A) et le profil sous la région d'isolation 20 (figure 6B) et pour un même potentiel (ici un potentiel nul) appliqué aux régions p+ 16 et 20 ; la profondeur est en abscisse orientée vers le bas ; le potentiel est en ordonnée vers !a droite. A une profondeur donnée, le potentiel dans la photodiode en l'absence de charges est toujours plus élevé que le potentiel dans la région d'isolation adjacente, de sorte que le puits de potentiel, peut se remplir de charges négatives en restant encadré par des barrières de potentiel retenant les charges.

La figure 7 représente une vue de dessus de deux pixels adjacents d'une même ligne Lⱼ de rang j, appartenant à deux colonnes voisines de rang i et i+1. Les photodiodes respectives sont désignées par PH1_{i,j} et PH2_{i,j} pour le premier pixel et PH1_{i+1,j} et Ph2_{i+1,j} pour le deuxième. Les régions d'isolation p+ entre pixels d'une même ligne sont désignées par la référence 20, et des contacts électriques 24 sont pris sur ces régions pour appliquer les potentiels Phi_{P1} et Phi_{P2} aux régions p+ des photodiodes. Les contacts peuvent être reliés à des lignes d'aluminium non représentées qui apportent de place en place les potentiels Phi_{P1} aux premières photodiodes et Phi_{P2} aux deuxièmes photodiodes. Les grilles G1 et G2 qui séparent les premières photodiodes des deuxièmes photodiodes s'étendent tout le long des lignes de pixels. Elles sont également pourvues de contacts répartis de place en place, contacts qui peuvent être reliés à des conducteurs en aluminium non représentés apportant les potentiels requis Phi_{G1} et Phi_{G2} à ces grilles.

La figure 8 représente une réalisation dans laquelle la forme géométrique de la surface des photodiodes est modifiée dans un sens qui facilite le déversement de charges d'une photodiode dans une autre : les coins des photodiodes tournés vers une photodiode adjacente sont biseautés et limitent la largeur des grilles de transfert entre deux photodiodes. Les régions d'isolation 20 sont évasées en conséquence.

La figure 9 représente un perfectionnement dans lequel on prévoit des dispositifs anti-éblouissement, situés dans les régions d'isolation 20. Une même structure d'anti-éblouissement peut servir pour deux pixels adjacents séparés par une région 20. La structure comprend de préférence une région centrale de type n+ constituant un drain, recouverte d'un contact de drain permettant de la porter à un potentiel d'alimentation positif ; ce drain est entièrement entouré latéralement par la région 20 de type p+ ; une grille de commande isolée recouvre un espace allant de la photodiode au drain. Le réglage du potentiel appliqué à cette grille définit le seuil d'éblouissement à partir duquel les charges générées dans la photodiode se déverseront dans le drain pour être évacuées. On peut prévoir que la commande de la structure d'anti-éblouissement est faite ligne par ligne (ou encore par groupe de lignes) et non globalement pour toutes les lignes, de sorte qu'on peut appliquer des potentiels différents aux grilles d'anti-éblouissement des différentes lignes ou différents groupes de lignes. Ceci permet en particulier de limiter à un nombre N' inférieur à N le nombre de lignes d'accumulation de charges effectivement utilisées dans une opération de capture d'image. Il suffit pour cela de porter à une valeur élevée le potentiel des grilles d'anti-éblouissement des premières lignes qu'on ne veut pas utiliser, de sorte que les charges engendrées dans les photodiodes de ces lignes se déversent systématiquement dans le drain d'anti-éblouissement au lieu d'être accumulées dans les photodiodes, seules les autres lignes accumulant des charges.

Si le substrat semiconducteur 10 était de type n++ avec une couche épitaxiale de type p, les moyens d'anti-éblouissement seraient différents : on se servirait du substrat n++ comme drain d'anti-ébouissement vertical au lieu d'une région n+ latérale, et on réglerait le seuil d'anti-éblouissement en appliquant une polarisation réglable à la couche épitaxiale.

La figure 10 représente une configuration possible d'un étage de lecture de charges placé à l'extrémité d'une colonne de pixels ; la coupe est dans le sens de la colonne, et on voit le dernier pixel P_{N} de la colonne suivi d'un étage de lecture CL. L'étage de lecture comprend de préférence une diffusion flottante 40 de type n, analogue à la diffusion d'une photodiode mais non recouverte d'une région superficielle p+, un transistor de lecture 42, et un transistor de remise à zéro constitué par un drain 44 à un potentiel de référence positif Vref et une grille isolée 46 séparant la diffusion flottante 40 du drain 44. Après la dernière étape d'intégration de charges dans la ligne de rang N, les charges contenues dans la deuxième photodiode du pixel P_{N} sont déversées dans la diffusion flottante 40, à travers une grille finale 48 qui peut être commandée par le potentiel Phi_{G1} comme s'il y avait un N+1^{ème} pixel après le pixel P_{N}.

Dans ce qui précède on a considéré que les deux photodiodes d'un pixel étaient identiques en géométrie, en surface, et en dopage de la région superficielle, mais ce n'est pas obligatoire.

Le capteur selon l'invention peut être éclairé par la face avant ou par la face arrière.

## Revendications

1. Capteur d'image à transfert de charges fonctionnant en défilement et intégration de charges, le capteur comportant N lignes adjacentes de P pixels en vue d'une observation d'une même ligne d'image successivement par plusieurs lignes de pixels avec une sommation des charges électriques générées par un point d'image dans les pixels de même rang des différentes lignes, les pixels adjacents de même rang comprenant une alternance d'au moins une photodiode (PH1, PH2) et une grille de transfert (G1, G2) adjacente à la photodiode, les photodiodes comprenant une région de référence commune (12) d'un premier type de conductivité, dans laquelle est formée une région individuelle (14) de type opposé elle-même recouverte par une région superficielle individuelle (16) du premier type, **caractérisé en ce que** les régions superficielles (16) de deux photodiodes situées de part et d'autre d'une grille de transfert sont électriquement isolées l'une de l'autre et électriquement isolées de la région de référence commune, et **en ce que** le capteur comporte des moyens pour porter ces régions à des potentiels différents l'un de l'autre et variables cycliquement.

2. Capteur d'image selon la revendication 1, **caractérisé en ce qu'**il comporte un circuit de séquencement pour appliquer cycliquement des potentiels aux grilles et aux photodiodes pour :
- créer un puits de potentiel sous une première photodiode pour y accumuler des charges ;
- en même temps monter le fond du puits de potentiel d'une deuxième photodiode adjacente à la première pour que les charges générées par la deuxième photodiode se déversent dans la première ;
- ensuite vider l'ensemble des charges de la première photodiode vers la deuxième ;
- puis recommencer un cycle dans lequel la deuxième photodiode, ayant déjà reçu des charges, joue le rôle d'une première photodiode vis-à-vis d'une autre photodiode appartenant à une autre ligne de pixels.

3. Capteur d'image selon la revendication 2, **caractérisé en ce qu'**un pixel d'une ligne de rang intermédiaire entre la première ligne et la dernière ligne comporte une succession, dans le sens perpendiculaire à la direction des lignes de pixels, d'une première grille de transfert (G1), permettant l'établissement d'une barrière de potentiel de hauteur variable, une première photodiode (PH1) adjacente à la première grille, une deuxième grille de transfert (G2) adjacente à la première photodiode et permettant l'établissement d'une barrière de potentiel de hauteur variable, et une deuxième photodiode (PH2) adjacente à la deuxième grille et adjacente à la première grille d'un pixel d'une ligne suivante.

4. Capteur d'image selon la revendication 3, **caractérisé en ce que** le circuit de séquencement est agencé pour appliquer aux photodiodes et aux grilles de toutes les lignes des potentiels qui varient périodiquement selon quatre phases successives :
- une première phase d'intégration dans laquelle les charges générées par la lumière dans la première photodiode d'un pixel sont accumulées par la première photodiode tandis que les charges générées par la lumière dans la deuxième photodiode se déversent de la deuxième photodiode vers la première en passant sous la deuxième grille et en s'accumulant dans la première photodiode,
- une première phase de transfert dans laquelle les charges accumulées dans la première photodiode sont transférées dans la deuxième photodiode,
- une deuxième phase d'intégration dans laquelle les charges générées par la lumière dans la deuxième photodiode sont accumulées par la deuxième photodiode tandis que les charges générées par la lumière dans la première photodiode du pixel de la ligne suivante se déversent vers la deuxième photodiode en passant sous la première grille du pixel de la ligne suivante et en s'accumulant dans la deuxième photodiode,
- et une deuxième phase de transfert dans laquelle les charges accumulées dans la deuxième photodiode sont transférées dans la première photodiode du pixel de la ligne suivante en passant sous la première grille de transfert du pixel de la ligne suivante.

5. Capteur selon la revendication 4, **caractérisé en ce que** les potentiels appliqués à la région superficielle de la deuxième photodiode respectivement pendant la première phase de transfert et pendant la deuxième phase d'intégration sont choisis de manière à créer un puits de potentiel sous la deuxième photodiode plus profond pendant la première phase de transfert que pendant la deuxième phase d'intégration.

6. Capteur selon la revendication 5, **caractérisé en ce que** les potentiels appliqués à la deuxième grille de transfert sont choisis de manière à abaisser la barrière de potentiel sous la deuxième grille de transfert pendant la première phase de transfert plus que pendant la première phase d'intégration.

7. Capteur selon l'une des revendications précédentes, **caractérisé en ce que** les photodiodes de pixels adjacents d'une même ligne sont séparées par des structures d'isolation comprenant la superposition
- d'une région d'isolation (20) du premier type de conductivité, adjacente aux régions superficielles (16) des photodiodes mais plus dopée que ces régions superficielles
- et d'une région d'isolation (22) du deuxième type de conductivité située au dessous de la région d'isolation du premier type et qui sépare complètement cette dernière de la région de référence commune du premier type.

8. Capteur selon la revendication 7, **caractérisé en ce que** le rapport entre les concentrations en impuretés de la région d'isolation du premier type et la région d'isolation du deuxième type est supérieur au rapport entre les concentrations en impuretés de la région superficielle et de la région individuelle du deuxième type d'une photodiode, de manière que les puits de potentiel créés dans la structure d'isolation soient moins profonds que ceux créés dans la photodiode.

9. Capteur selon l'une des revendications 7 et 8, **caractérisé en ce qu'**un contact électrique est prévu sur les régions d'isolation (20) du premier type pour amener un potentiel aux régions superficielles (16).

10. Capteur selon l'une des revendications 7 à 9, **caractérisé en ce qu'**il comporte une structure d'anti-éblouissement comportant un drain de type N dans la région d'isolation du premier type et une grille de commande recouvrant un espace allant de la photodiode au drain.

11. Capteur selon l'une des revendications 7 à 10, **caractérisé en ce que** les coins des photodiodes tournés vers une photodiode adjacente sont biseautés pour limiter la largeur des grilles de transfert entre deux photodiodes.

## Patentansprüche

1. Bildsensor mit Ladungsübertragung, der durch Laufenlassen und Integrieren von Ladungen arbeitet, wobei der Sensor N benachbarte Leistungen von P Pixeln hinsichtlich einer Beobachtung von derselben Bildleitung nacheinander durch mehrere Pixelleitungen unter Summierung von elektrischen Ladungen umfasst, die von eine Bildpunkt in den Pixeln desselben Rangs von unterschiedlichen Leitungen erzeugt werden, wobei die benachbarten Pixel desselben Rangs abwechselnd wenigstens eine Fotodiode (PH1, PH2) und ein Übertragungsgatter (G1, G2) neben der Fotodiode umfassen, wobei die Fotodioden eine gemeinsame Referenzregion (12) eines ersten Leitfähigkeitstyps haben, in der eine individuelle Region (14) des entgegengesetzten Typs ausgebildet ist, die wiederum von einer individuellen Oberflächenregion (16) des ersten Typs bedeckt ist, dadurch gekenntzeichnet, dass die Oberflächenregionen (16) von zwei auf beiden Seiten eines Übertragungsgatters befindlichen Fotodioden elektrisch voneinander der isoliert und elektrisch von der gemeinsamen Referenzregion isoliert sind, und dadurch, dass der Sensor Mittel umfasst, um diese Regionen auf unterschiedliche und zyklisch variiende Potentiale zu bringen.

2. Bildsensor nach Anspruch 1, **dadurch gekennzeichnet, dass** er eine Sequenzierungsschaltung zum zyklischen Anlegen der Potentiale an die Gatter und die Fotodioden umfasst zum:
- Erzeugen von Potentialmulden unter einer ersten Fotodiode, um dort Ladungen anzusammeln;
- gleichzeitig Erhöhen des Bodens der Potentialmulden von einer zweiten Fotodiode neben der ersten, damit sich die von der zweiten Fotodiode erzeugten Ladungen in die erste ergießen;
- dann Entleeren aller Ladungen der ersten Fotodiode in die zweite;
- dann erneutes Beginnen eines Zyklus, in dem die zweite Fotodiode, die bereits Ladungen empfangen hat, die Rolle einer ersten Fotodiode gegenüber einer anderen Fotodiode spielt, die zu einer anderen Pixelleitung gehört.

3. Bildsensor nach Anspruch 2, **dadurch gekennzeichnet, dass** ein Pixel einer Leitung mit eine Zwischenring zwischen der ersten Leitung und der letzten Leitung eine Folge, lotrecht zur Richtung der Pixelleitungen, aus eine ersten Übertragungsgatter (G1), das das Einrichten einer Potentialbarriere von variabler Höhe zulässt, einer ersten Fotodiode (PH1) neben dem ersten Gatter, eine zweiten Übertragungsgatter (G2) neben der ersten Fotodiode, das das Einrichten einer Potentialbarriere mit veränderliche Höhe zulässt, un einer zweiten Fotodiode (PH12) neben dem zweiten Gatter und neben dem ersten Gatter von einem Pixel einer folgenden Leitung umfasst.

4. Bildsensor nach Anspruch 3, **dadurch gekennzeichnet, dass** die Sequenzierungsschaltung so ausgelegt ist, dass sie Potentiale an die Fotodioden und die Gatter aller Leistungen anlegt, die periodisch gemäß vier aufeinander folgenden Phasen variierten:
- eine erste Integrationsphase, in der die durch das Licht in der ersten Fotodiode eines Pixels erzeugten Ladungen von der ersten Fotodiode gesammelt werden, während sich die vom Licht in der zweiten Fotodiode erzeugten Ladungen von der zweiten Fotodiode in die erste ergießen, während sie unter dem zweiten Gatter passieren und sich in der ersten Fotodiode ansammeln,
- eine erste Übertragungsphase, in der die in der ersten Fotodiode angesammelten Ladungen in die zweite Fotodiode übertragen werden,
- eine zweite Integrationsphase, in der die vom Licht in der zweiten Fotodiode erzeugten Ladungen von der zweiten Fotodiode angesammelt werden, während sich die vom Licht in der ersten Fotodiode erzeugten Ladungen des Pixels der folgenden Leitung in die zweite Fotodiode ergießen, während sie unter dem ersten Gatter des Pixels der folgenden Leitung passieren und sich in der zweiten Fotodiode ansammeln,
- und eine zweite Übertragungsphase, in der die in der zweiten Fotodiode angesammelten Ladungen in die erste Fotodiode des Pixels der folgenden Leitung übertragen werden, während sie unter dem ersten Übertragungsgatter des Pixels der folgenden Leistung passieren.

5. Sensor nach Aspruch 4, **dadurch gekennzeichnet, dass** die jeweils während der ersten Übertragungsphase und während der zweiten Integrationsphase an die Oberflächenregion der zweiten Fotodiode angelegten Potentiale so gewählt werden, dass eine Potentialmulde unter der zweiten Fotodiode entsteht, die während der ersten Übertragungsphase tiefer ist als während der zweiten Integrationsphase.

6. Sensor nach Anspruch 5, **dadurch gekennzeichnet, dass** die an das zweite Übertragungsgatter angelegten Potentiale so gewählt werden, dass die Potentialbarriere unter dem zweiten Übertragungsgatter während der ersten Übertragungsphase stärker absinkt als während der ersten Integrationsphase.

7. Sensor nach einem der vorherigen Anspruche, **dadurch gekennzeichnet, dass** die Fotodioden von benachbarten Pixeln einer selben Leitung durch Isolationsstrukturen getrennt werden, die die Übereinanderlagerung beinhalten von:
- einer Isolationsregion (20) des ersten Leitfähigkeitstyps neben den Oberflächenregionen (16) von Fotodiode, aber stärker dotiert als diese Oberflächenregionen,
- und von einer Isolationsregion (22) des zweiten Leitfähigkeitstyps, die sich unter der Isolationsregion des ersten Typs befindet und diese letztere völlig von der gemeinsamen Referenzregion des ersten Typs trennt.

8. Sensor nach Anspruch 7, **dadurch gekennzeichnet, dass** das Verhältnis zwischen den Verunreinigungskonzentrationen der Isolationsregion des ersten Typs und der Isolationsregion des zweiten Typs größer ist als das Verhältnis zwischen den Verunreinigungskonzentrationen der Oberflächenregionen und der individuellen Region des zweiten Typs einer Fotodiode, so dass die in der Isolationsstruktur erzeugten Potentialmulden weniger tief sind als die, die in der Fotodiode erzeugt worden.

9. Sensor nach einem der Ansprüche 7 und 8, **dadurch gekennzeichnet**, ass ein elektrischer Kontakt auf den Isolationsregionen (20) des ersten Typs vorgesehen ist, um ein Potential zu den Oberflächenregionen (16) zu führen.

10. Sensor nach eine der Ansprüche 7 bis 9, **dadurch gekennzeichnet, dass** er eine blendfreie Struktur umfasst, die einen Drain des N-Typs in der Isolationsregion des ersten Typs und ein Steuergatter umfasst, das einen von der Fotodiode zum rain verlaufenden Raum bedeckt.

11. Sensor nach eine der Ansprüche 7 bis 10, **dadurch gekennzeichnet, dass** die Ecken der zu einer benachbarten Fotodiode gedrehten Fotodioden abgeschrägt sind, um die Breite der Übertragungsgatter zwischen zwei Fotodioden zu begrenzen.

## Claims

1. Charge-transfer image sensor operating in time-delay and integration mode, the sensor comprising N adjacent rows of P pixels with a view to using several rows of pixels in succession to observe one and the same image row by summing the electric charges generated by an image point in the pixels of the same rank of the various rows, the adjacent pixels of the same rank comprising, alternately, at least one photodiode (PH1, PH2) and one transfer gate (G1, G2) adjacent to the photodiode, the photodiodes comprising a common reference region (12) of a first conductivity type, in which an individual region (14) of opposite conductivity is formed, itself covered by an individual surface region (16) of the first conductivity type, **characterized in that** the surface regions (16) of two photodiodes located on either side of a transfer gate are electrically isolated from each other and electrically isolated from the common reference region, and **in that** the sensor comprises means of bringing these regions to potentials that are different from each other and are cyclically variable.

2. Image sensor according to Claim 1, **characterized in that** it comprises a sequencing circuit for applying potentials cyclically to the gates and to the photodiodes so as to:
- create a potential well beneath a first photodiode so as to accumulate charges therein;
- at the same time, raise the bottom of the potential well of a second photodiode adjacent to the first so that the charges generated by the second photodiode flow into the first;
- next, empty all the charges from the first photodiode into the second; and
- then, restart a cycle in which the second photodiode, having already received charges, acts as a first photodiode with respect to another photodiode belonging to another row of pixels.

3. Image sensor according to Claim 2, **characterized in that** a pixel in a row of rank intermediate between the first row and the last row comprises, in succession, in the direction perpendicular to the direction of the rows of pixels, a first transfer gate (G1) allowing a variable-height potential barrier to be established, a first photodiode (PH1) adjacent to the first gate, a second transfer gate (G2), allowing a variable-height potential barrier to be established, and a second photodiode adjacent to the second gate and adjacent to the first gate of a pixel in the next row.

4. Image sensor according to Claim 3, **characterized in that** the sequencing circuit is designed to apply, to the photodiodes and to the gates of all the rows, potentials that vary periodically in four successive phases:
- a first integration phase in which the charges generated in the first photodiode of a pixel by the light are accumulated by the first photodiode whilst the charges generated by the light in the second photodiode flow from the second photodiode into the first by passing beneath the second gate and accumulating in the first photodiode;
- a first transfer phase in which the charges accumulated in the first photodiode are transferred to the second photodiode;
- second integration phase in which the charges generated by the light in the second photodiode are accumulated by the second photodiode whilst charges generated by the light in the first photodiode of the pixel in the next row flow into the second photodiode by passing beneath the first gate of the pixel in the next row and accumulate in the second photodiode; and
- a second transfer phase in in which the charges accumulated in the second photodiode are transferred to the first photodiode of the pixel in the next row by passing beneath the first transfer gate of the pixel in the next row.

5. Sensor according to Claim 4, **characterized in that** at the potentials applied to the surface region of the second photodiode during the first transfer phase and during the second integration phase, respectively, are chosen so as to create a deeper potential well beneath the second photodiode during the first transfer phase than during the second integration phase.

6. Sensor according to Claim 5, **characterized in that** the potentials applied to the second transfer gate are chosen to lower the potential barrier beneath the second transfer gate during the first transfer phase more than during the first integration phase.

7. Sensor according to one of the preceding claims, **characterized in that** the photodiodes of adjacent pixels in one and the same row are separated by isolating structures comprising the superposition of:
- an isolating region (20) of the first conductivity type, adjacent to the surface regions (16) of the photodiodes, but more heavily doped than these surface regions; and
- an isolating region (22) of the second conductivity type located beneath the isolating region of the first conductivity type and completely separating the latter from the common reference region of the first conductivity type.

8. Sensor according to Claim 7, **characterized in that** the ratio of the impurity concentration in the isolating region of the first conductivity type to the impurity concentration in the isolating region of the second conductivity type is higher than the ratio of the impurity concentration in the surface region to the impurity concentration in the individual region of the second conductivity type of a photodiode, so that the potential wells created in the isolating structure are shallower than those created in the photodiode.

9. Sensor according to either of Claims 7 and 8, **characterized in that** an electrical contact is provided on the isolating regions (20) of the first conductivity type so as to deliver a potential to the surface regions (16).

10. Sensor according to one of Claims 7 to 9, **characterized in that** it comprises an anti-blooming structure comprising an n-type drain in the isolating region of the first conductivity type and a control gate covering a space running from the photodiode to the drain.

11. Sensor according to one of Claims 7 to 10, **characterized in that** the corners of the photodiodes turned towards an adjacent photodiode are bevelled so as to limit the width of the transfer gates between two photodiodes.
